# EUROPÄISCHE PATENTSCHRIFT

(11) **EP 3 503 399 B1**
(45) Veröffentlichungstag und Bekanntmachung des Hinweises auf die Patenterteilung: **20.08.2025**
(21) Anmeldenummer: 18211557.6
(22) Anmeldetag: 11.12.2018
(51) Int. Cl.: H03K 17/30, H03K 17/78, H03K 17/795

(54) **DIGITALE EINGANGSSCHALTUNG ZUM EMPFANGEN DIGITALER EINGANGSSIGNALE EINES SIGNALGEBERS**
DIGITAL INPUT SWITCHING FOR RECEIVING DIGITAL INPUT SIGNALS OF A SIGNAL PROVIDER
CIRCUIT D'ENTRÉE NUMÉRIQUE DESTINÉ À LA RÉCEPTION DES SIGNAUX D'ENTRÉE NUMÉRIQUES D'UN GÉNÉRATEUR DE SIGNAUX

(30) Priorität: 22.12.2017 DE 102017131200
(43) Veröffentlichungstag der Anmeldung: 26.06.2019
(73) Patentinhaber: Pilz GmbH & Co. KG, 73760 Ostfildern (DE)
(72) Erfinder: Harrer, Bernd, 73760 Ostfildern (DE)
(74) Vertreter: Manske, Jörg

(56) Entgegenhaltungen:
- EP-A1- 1 261 120
- EP-A2- 2 506 436
- US-A- 6 043 703

## Beschreibung

Die vorliegende Erfindung betrifft eine digitale Eingangsschaltung zum Empfangen digitaler Eingangssignale eines Signalgebers nach dem Oberbegriff des Anspruchs 1.

Ein derzeit in der Technik zu beobachtender Trend ist die stetig weiter fortschreitende Miniaturisierung von Geräten und Gerätekomponenten, insbesondere auch von elektrischen und elektronischen Geräten und Gerätekomponenten. Oftmals geht dieser Trend zur Miniaturisierung mit einer gleichzeitigen Vergrößerung des Funktionsumfangs der Geräte beziehungsweise der Gerätekomponenten einher. Dadurch erhöht sich zum Beispiel bei Schaltvorrichtungen oder bei Sicherheitsschaltvorrichtungen, welche für sicherheitsgerichtete Anwendungen, insbesondere in automatisiert arbeitenden technischen Anlagen, vorgesehen sind, die Anzahl der Eingänge zum Empfangen analoger oder digitaler Eingangssignale unterschiedlicher Signalgeber. Diese analogen oder digitalen Eingangssignale stammen zum Beispiel von Sensoreinrichtungen oder Meldegeräten, wie zum Beispiel Not-Aus-Tastern, Not-Halt-Tastern, Schutztüren, Schaltmatten, Zwei-Hand-Schaltern, Endlagenschaltern und anderen Positionsschaltern.

Digitale Eingangssignale sind binäre Signale und zeichnen sich durch zwei definierte Zustände aus, die beispielsweise durch zwei statische Potentiale definiert sein können. Diese binären Zustände sind durch verschiedene Spannungszustände gekennzeichnet, wobei ein erster Zustand dann eingenommen wird, wenn ein definierter Spannungsschwellwert erreicht oder unterschritten wird. Dabei handelt es sich um einen so genannten Low-Pegel-Zustand. Ein zweiter Zustand wird dann eingenommen, wenn ein definierter Spannungsschwellwert erreicht oder überschritten wird. Dabei handelt es sich um einen so genannten High-Pegel-Zustand. Bekannte digitale Eingangsschaltungen sind z. B. in EP1261120A1, US6043703A oder EP2506436A2 offenbart.

Digitale Eingangsschaltungen der eingangs genannten Art zum Empfangen digitaler Eingangssignale eines Signalgebers mit zumindest einem Eingang sind aus dem Stand der Technik in ganz unterschiedlichen Ausführungsformen bekannt. Bei stromziehenden digitalen Eingangsschaltungen, die typischerweise mit einer Betriebsspannung von 24 V (DC) betrieben werden, wird gemäß der Norm EN 61131-2:2007 zwischen drei verschiedenen Typen (Typ 1, Typ 2 und Typ 3) unterschieden. Diese drei Typen digitaler Eingangsschaltungen unterscheiden sich insbesondere in ihren High-Pegeln, ihren Low-Pegeln und in ihren Stromaufnahmen voneinander.

Digitale Eingangsschaltungen des Typs 1 müssen spätestens bei einer Eingangsspannung von 15 V zwingend einen High-Pegel erkennen. In der Praxis wird dieser High-Pegel daher bereits bei einer Eingangsspannung < 15 V erfasst. Digitale Eingangsschaltungen des Typs 1 müssen ferner in einem gesamten Eingangsspannungsbereich von 15 V bis 30 V einen High-Pegel erkennen. Die Stromaufnahme ist im High-Pegel-Bereich ≥ 2 mA und kann bis zu 15 mA betragen. Digitale Eingangsschaltungen des Typs 1 (wie auch der weiter unten genannten Typen 2 und 3) müssen ferner dazu in der Lage sein, in einem gesamten Bereich von -3 V bis 5 V einen Low-Pegel zu erkennen. In der Praxis wird ein Low-Pegel daher bereits bei Eingangsspannungen > 5 V erfasst. Im Bereich von -3 V bis 5 V darf der Eingangsstrom zwischen 0 mA und 15 mA liegen. Eine Stromgrenze von 0,5 mA ist dann relevant, wenn die Eingangsspannung zwischen 5 V und 15 V liegt. In diesem Bereich muss der Eingang ebenfalls einen Low-Pegel erkennen, sofern der Eingangsstrom ≤ 0,5mA beträgt. Derartige digitale Eingangsschaltungen des Typs 1 werden insbesondere für **elektromechanische** Schaltvorrichtungen, wie zum Beispiel Drucktaster oder Relaiskontakte, oder auch für 3-Leiter-Sensoreinrichtungen verwendet. Ein typisches Anwendungsbeispiel für digitale Eingangsschaltungen des Typs 1 sind Not-Aus-Schaltvorrichtungen.

Digitale Eingangsschaltungen des Typs 2 eignen sich zum Beispiel für 2-Leiter-Sensoreinrichtungen und für Halbleitersensoren, die für ihren Betrieb einen relativ hohen Ruhestrom erfordern. Die Stromaufnahme im High-Pegel-Bereich, der zwischen 11 V und 30 V liegt, ist typischerweise ≥ 6 mA und kann bis zu 30 mA betragen.

Digitale Eingangsschaltungen des Typs 3 zeichnen sich gerade bei hohen elektrischen Spannungen durch eine im Vergleich zu digitalen Eingangsschaltungen des Typs 2 geringere Leistungsaufnahme und Abwärme aus, so dass mehr digitale Eingangsschaltungen zu einem digitalen Eingangsmodul zusammengefasst werden können als bei digitalen Eingangsschaltungen des Typs 2. Digitale Eingangsschaltungen des Typs 3 müssen im Eingangsspannungsbereich zwischen 11 V und 30 V einen High-Pegel erkennen. Die Stromaufnahme ist im High-Pegel-Bereich, der zwischen 11 V und 30 V liegt, typischerweise ≥ 2 mA und kann bis zu 15 mA betragen. Im Eingangsspannungsbereich zwischen -3 V und 5 V müssen digitale Eingangsschaltungen des Typs 3 einen Low-Pegel bei einer zulässigen Stromaufnahme zwischen 0 mA und 15 mA erkennen. Zusätzlich muss ein Low-Pegel erkannt werden, wenn die Eingangsspannung zwischen 5 V und 11 V liegt und der Eingangsstrom ≤ 1,5mA beträgt.

Der oben bereits erwähnte Trend zur Miniaturisierung bei gleichzeitiger Erhöhung der Anzahl der Funktionen erfordert neben der Verwendung immer kleiner werdender Bauelemente auch eine ständige Reduktion der Verlustleistung der eingesetzten Bauelemente und der verwendeten Schaltungen. Dieses gilt ganz besonders auch für die beispielsweise zur Verarbeitung von Sensorsignalen oder Signalen von Meldegeräten benötigten digitalen Eingangsschaltungen. Bei diesen muss es daher das Ziel sein, den Eingangsstrom bei Eingangsspannungen, welche dem zweiten Zustand (also dem logischen High-Pegel) entsprechen, möglichst gering zu halten. Das ist insbesondere im Bereich der größten auftretenden Eingangsspannungen wichtig, da dann üblicherweise auch die größten Ströme fließen und folglich auch die größten Verlustleistungen auftreten. Gleichzeitig gibt es oftmals jedoch auch Anforderungen an einen minimalen Eingangsstrom, der beim Erreichen des oberen Schwellwertes, der den Beginn des High-Pegel-Bereichs definiert, nicht unterschritten werden darf.

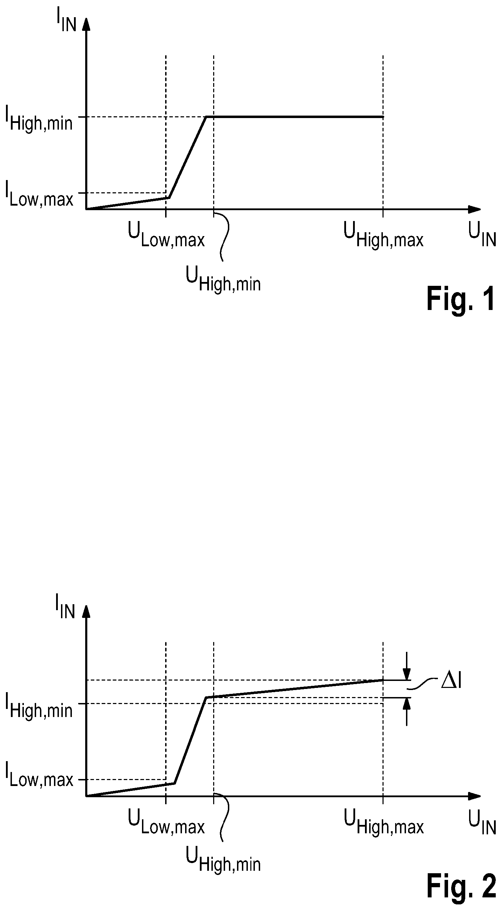

Eine hinsichtlich ihrer minimalen Verlustleistungsaufnahme optimale digitale Eingangsschaltung weist einen Verlauf ihrer Eingangsstrom-Eingangsspannungs-Kennlinie auf, wie er in Fig. 1 dargestellt ist. Diese Abbildung zeigt den Verlauf des Eingangsstroms I_{IN} der digitalen Eingangsschaltung in Abhängigkeit von der Eingangsspannung U_{IN}. Der Low-Pegel-Bereich wird durch eine Eingangsspannung U_{IN} ≤ U_{Low,max} sowie durch einen Eingangsstrom I_{IN} ≤ I_{Low,max} definiert. Der High-Pegel-Bereich wird durch eine Eingangsspannung U_{High,min} ≤ U_{IN} ≤ U_{High,max} und durch einen Eingangsstrom I_{IN} = I_{High,min} definiert. Zwischen dem Low-Pegel-Bereich und dem High-Pegel-Bereich existiert ein Übergangsbereich zwischen der Eingangsspannung U_{IN} > U_{Low,max} sowie U_{IN} < U_{High,min} in dem ein Eingangsstrom I_{Low,max} < I_{IN} < I_{High,min} fließt. Wie oben bereits erwähnt, werden in der praktischen Anwendung der High-Pegel-Zustand und der Low-Pegel-Zustand bereits bei Eingangsspannungen erfasst, die innerhalb des Übergangsbereichs liegen. Ein wesentliches Merkmal dieses idealisierten Kennlinienverlaufs ist der konstante Eingangsstrom I_{IN} = I_{High,min} im High-Pegel-Bereich der digitalen Eingangsschaltung. Das bedeutet, dass der Eingangsstrom I_{IN} im High-Pegel-Bereich sich im Idealfall trotz steigender Eingangsspannung U_{IN} nicht weiter erhöht.

Fig. 2 zeigt demgegenüber den Verlauf der Eingangsstrom-Eingangsspannungs-Kennlinie einer realen digitalen Eingangsschaltung, die eine nicht optimale Verlustleistungsaufnahme aufweist, da im zweiten Zustand (High-Pegel-Bereich) ein nicht-ideales Stromaufnahmeverhalten vorliegt. Aufgetragen ist wiederum der Verlauf des Eingangsstroms I_{IN} der digitalen Eingangsschaltung in Abhängigkeit von der Eingangsspannung U_{IN}. Der Kennlinienverlauf, wie er in Fig. 2 gezeigt ist, unterscheidet sich von dem in Fig. 1 dargestellten idealisierten Kennlinienverlauf im Wesentlichen dadurch, dass der Eingangsstrom I_{IN} auch im High-Pegel-Bereich noch weiter (mehr oder weniger stark) ansteigt. Mit immer größer werdender Eingangsspannung U_{IN} gilt somit: I_{IN} > I_{High,min}. Der daraus resultierende Anstieg ΔI des elektrischen Eingangsstroms I_{IN} führt mit zunehmender Eingangsspannung U_{IN} zu einer deutlich stärkeren Zunahme der elektrischen Verlustleistung als dieses bei einem Kennlinienverlauf einer idealen digitalen Eingangsschaltung, wie er in Fig.1 gezeigt ist, der Fall ist.

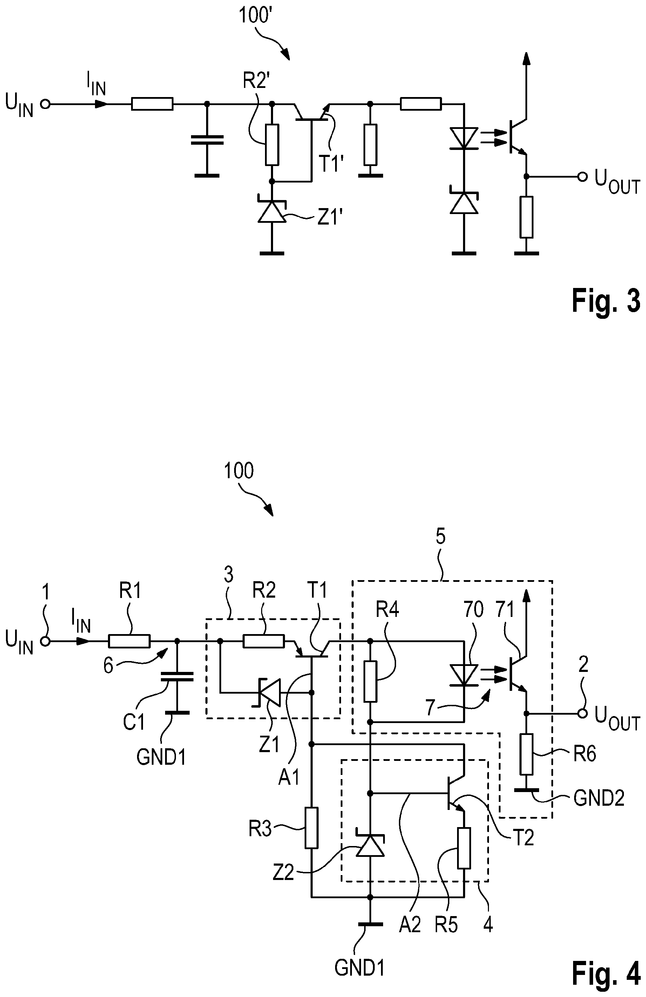

Im Stand der Technik wird zur Stabilisierung des Eingangsstroms einer digitalen Eingangsschaltung zum Beispiel eine Schaltungsanordnung eingesetzt, wie sie in Fig. 3 dargestellt ist. Die Schaltungsanordnung der digitalen Eingangsschaltung 100' weist einen sehr einfach aufgebauten Spannungsregler auf, der einen Bipolartransistor (npn-Transistor) T1', eine Z-Diode Z1' sowie einen Vorwiderstand R2' für die Z-Diode Z1' umfasst. Mittels der Z-Diode Z1' kann eine Spannungsbegrenzung erreicht werden. Damit die Ausgangsspannung eines derart aufgebauten Spannungsreglers eine gute Stabilisierung aufweist, ist es erforderlich, dass die Z-Diode Z1' in ihrem Stabilisierungsbereich (d.h. mit einem kleinen differentiellen Widerstand) oder zumindest nahe an diesem betrieben wird. Dazu muss allerdings der Vorwiderstand R2' der Z-Diode Z1' des Spannungsreglers hinreichend klein gewählt werden. Dieses hat bei zunehmender Eingangsspannung (Uᵢₙ > U_{High,min}) jedoch den Nachteil, dass der Strom durch den Vorwiderstand R2' und die Z-Diode Z1' und damit einhergehend auch der Eingangsstrom der digitalen Eingangsschaltung 100' selbst weiter signifikant zunehmen. Der Stromanstieg ΔI im High-Pegel-Bereich kann somit keinesfalls sehr klein gehalten werden. Daher hat eine an sich wünschenswerte gute Stabilisierung der Ausgangsspannung des Spannungsreglers bei zunehmender Eingangsspannung einen deutlich zunehmenden Eigenstrombedarf des Spannungsreglers zur Folge.

Wenn demgegenüber jedoch der Vorwiderstand R2' vergrößert wird, so verschlechtert sich die Stabilität der Ausgangsspannung des Spannungsreglers in dem Maße wie der Vorwiderstand R2' vergrößert wird. Der Arbeitspunkt der zur Stabilisierung der Ausgangsspannung eingesetzten Z-Diode Z1' kann sich dann sehr schnell in den Sperrbereich der Z-Diode Z1' bewegen. In diesem Bereich ist der differentielle Widerstand der Z-Diode Z1' bekanntlich sehr groß. Das hat den Nachteil, dass die tatsächliche Ausgangsspannung des Spannungsreglers nicht nur relativ stark von der Eingangsspannung U_{IN}, sondern auch stark vom verwendeten Exemplar der Z-Diode Z1' abhängt. Dieses wiederum kann dazu führen, dass die Ausgangsspannung des Spannungsreglers - zumindest bei einer Eingangsspannung U_{IN} = U_{High,min} - nicht den zum Erkennen eines High-Pegel-Zustands mindestens erforderlichen Wert erreicht. Die digitale Eingangsschaltung erkennt somit erst bei Eingangsspannungen U_{IN} > U_{High,min} einen High-Pegel-Zustand oder im Extremfall nicht einmal dann.

Neben der mangelnden Zuverlässigkeit einer derart aufgebauten Eingangsschaltung 100' ist auch die Zunahme des Eingangsstroms I_{IN} mit steigender Eingangsspannung U_{IN} trotz eines relativ großen Vorwiderstands R2' der Z-Diode Z1' oftmals nicht zu vernachlässigen. Diese Zunahme des Eingangsstroms I_{IN} mit steigender Eingangsspannung U_{IN} ist insbesondere dann zu beachten, wenn mehrere digitale Eingangsschaltungen zur Bildung eines digitalen Eingangsmoduls in einem einzigen Gehäuse mit einem begrenzten Verlustleistungsaufnahmevermögen untergebracht werden müssen.

Bei anderen aus dem Stand der Technik bekannten digitalen Eingangsschaltungen wird eine Stabilisierung des Eingangsstroms mittels einer einzelnen Stromquelle realisiert. Die oben beschriebenen Nachteile der Schaltungsanordnung (d.h. der Stromanstieg ΔI im High-Pegel-Bereich, wie er in Fig. 2 gezeigt ist, und eine mangelnde Zuverlässigkeit) treten auch bei der Verwendung typischer realer Stromquellen auf. Ein Beispiel für eine derartige Ausführungsform ist aus der EP 1 906 533 A1 bekannt. Dort wird eine zusätzliche Stromquelle für die Einstellung eines Ruhestroms im Low-Pegel-Bereich für den Anschluss von Näherungsschaltern verwendet.

Aus der EP 1 261 120 A1 ist eine Eingangsschaltung bekannt, die zwei Stromquellen, einen ohmschen Zwischenwiderstand und als Baugruppe zur galvanischen Trennung einen Opto-Koppler beinhaltet. Der Zwischenwiderstand und der Opto-Koppler sind jeweils zwischen die beiden Stromquellen geschaltet. Diese Eingangsschaltung ist für einen Eingangsspannungsbereich von 10 Volt bis 72 Volt ausgelegt. Solche relativ hohen Schwankungen der Eingangsspannung kommen beispielsweise im Eisenbahnsignaltechnikbereich vor.

Um eine digitale Eingangsschaltung mit einer möglichst geringen elektrischen Verlustleistung zu erhalten, sollte diese idealerweise einen Verlauf ihrer Eingangsstrom-Eingangsspannungs-Kennlinie im logischen High-Pegel-Bereich aufweisen, welcher dem in Fig. 1 dargestellten Kennlinienverlauf möglichst nahe kommt. Es geht also im Wesentlichen darum, die in der Eingangsstrom-Eingangsspannungs-Kennlinie gemäß Fig. 2 dargestellte Zunahme des Eingangsstroms **ΔI** bei zunehmender Eingangsspannung U_{IN} > U_{High,min} möglichst zu minimieren. Zusätzlich sollte auch der minimale Eingangsstrom I_{IN} im High-Pegel-Bereich möglichst nahe am mindestens erforderlichen Eingangsstrom I_{High,min} liegen. Eine weitere Zielvorgabe besteht darin, die digitale Eingangsschaltung möglichst einfach und damit auch kostengünstig zu realisieren.

Die Erfindung macht es sich somit zur Aufgabe, eine digitale Eingangsschaltung der eingangs genannten Art zur Verfügung zu stellen, die eine zuverlässige Erkennung von High-Pegel- und Low-Pegel-Zuständen des Eingangssignals sowie einen besonders verlustarmen Betrieb im High-Pegel-Bereich ermöglicht und dabei einfach und kostengünstig ausgeführt ist.

Die Lösung dieser Aufgabe liefert eine digitale Eingangsschaltung der eingangs genannten Art mit den Merkmalen des kennzeichnenden Teils des Anspruchs 1. Die Unteransprüche betreffen vorteilhafte Weiterbildungen der Erfindung.

Erfindungsgemäß wird vorgeschlagen, dass die digitale Eingangsschaltung einen hochohmigen Widerstand aufweist, über den die erste Teilschaltung mit Masse verbunden ist und dessen Widerstandswert ≥ 750 kOhm ist, wobei der hochohmige Widerstand einen Vorwiderstand der Z-Diode der ersten Teilschaltung bildet und direkt mit Masse verbunden ist. Dieser hochohmige Widerstand hat insbesondere die Funktion, sicherzustellen, dass bei einer Erhöhung der Eingangsspannung U_{IN} (ausgehend von 0 V) überhaupt ein Strom in den Eingang fließen kann. Dieser Widerstand dient somit gewissermaßen als "Anlauf"- bzw. "Startwiderstand". Konkret ermöglicht dieser Widerstand in der "Einschaltphase", dass im Ansteuerkreis des stromstabilisierenden Elements der ersten Teilschaltung ein Strom fließen kann. Dieser Strom wiederum ist Voraussetzung dafür, dass die erste Teilschaltung einen Strom liefern kann. Dieser Strom ist Voraussetzung für einen Stromfluss im Ansteuerkreis des stromstabilisierenden Elements der zweiten Teilschaltung, der schließlich einen Stromfluss in die zweite Teilschaltung ermöglicht.

Bei der digitalen Eingangsschaltung ist ferner vorgesehen, dass die erste Teilschaltung und die zweite Teilschaltung so ausgeführt und derart miteinander verschaltet sind, dass zumindest in dem zweiten Zustand ein elektrischer Strom, der durch das spannungsstabilisierende Element der ersten Teilschaltung fließt, nahezu vollständig aus einem stabilisierten Strom der zweiten Teilschaltung besteht und ein elektrischer Strom, der durch das spannungsstabilisierende Element der zweiten Teilschaltung fließt, nahezu vollständig aus einem stabilisierten Strom der ersten Teilschaltung besteht, so dass sich das nicht-ideale Stromausgabeverhalten der ersten Teilschaltung und das nicht-ideale Stromausgabeverhalten der zweiten Teilschaltung zumindest in dem zweiten Zustand gegenseitig zumindest teilweise kompensieren. Die Schaltungsarchitektur der digitalen Eingangsschaltung zeichnet sich somit durch die Verwendung mindestens zweier Teilschaltungen aus, die Stromquellen bilden, wobei diese Teilschaltungen vorzugsweise kreuzweise derart hintereinander geschaltet sind, dass zumindest für Eingangssignale im High-Pegel-Bereich (oder zumindest in einem Teil des High-Pegel-Bereiches), welcher den zweiten Zustand der digitalen Eingangsschaltung definiert, der elektrische Strom, der durch das spannungsstabilisierende Element der ersten Teilschaltung fließt, im Wesentlichen aus dem stabilisierten Strom der zweiten Teilschaltung besteht und der elektrische Strom, der durch das spannungsstabilisierende Element der zweiten Teilschaltung fließt, im Wesentlichen aus einem stabilisierten Strom der ersten Teilschaltung besteht. Dadurch wird erreicht, dass im Bereich der ersten und zweiten Teilschaltung zwei parallele konstante beziehungsweise im Wesentlichen konstante Ströme fließen. Mit dieser Schaltungsarchitektur lässt sich auf überraschend einfache und kostengünstige Weise eine digitale Eingangsschaltung realisieren, deren Eingangsstrom-Eingangsspannungs-Kennlinie im Bereich des zweiten Zustands, der durch den High-Pegel-Bereich gebildet ist, nahezu den optimalen Verlauf nach Fig. 1 aufweist. Die Ströme der beiden Ansteuerkreise machen im zweiten Zustand (High-Pegel-Bereich) nur noch einen kleinen Teil der Ströme der beiden Teilschaltungen aus. Der Stromanstieg ΔI gemäß Fig. 2 tendiert auch bei Eingangsspannungen U_{IN} > U_{High,min} gegen null, so dass die elektrische Verlustleistung im zweiten Zustand der digitalen Schaltungsanordnung in vorteilhafter Weise minimiert werden kann. Die digitale Eingangsschaltung eignet sich insbesondere auch für digitale Eingangsmodule, die mehrere digitale Eingangsschaltungen umfassen, welche in einem einzigen Gehäuse mit einem begrenzten Verlustleistungsaufnahmevermögen untergebracht sind.

Die spannungsstabilisierenden Elemente der ersten und der zweiten Teilschaltung sind Z-Dioden, die in dem zweiten Zustand in ihrem Stabilisierungsbereich betrieben werden. Die Schaltungsarchitektur ermöglicht es, dass bei Verwendung von Z-Dioden für die erste Teilschaltung und für die zweite Teilschaltung deren Dimensionierung sehr einfach so gewählt werden kann, dass zumindest für Eingangssignale im High-Pegel-Bereich durch beide Z-Dioden ein ausreichend großer Strom fließt, um diese in ihrem Stabilisierungsbereich oder zumindest nahe an diesem betreiben zu können. Die gute gegenseitige Stabilisierung der Ströme der beiden Teilschaltungen (und somit des gesamten Eingangsstroms) bei dieser Schaltungsarchitektur beruht darauf, dass die Ströme der Z-Dioden und in Folge davon auch die Spannungen der Z-Dioden stabil gehalten werden. Die gegenseitige Stabilisierung der Ströme der beiden Teilschaltungen ist am größten, wenn sich die Z-Dioden in ihrem Stabilisierungsbereich befinden. Dieses wird in vorteilhafter Weise ohne eine nachteilige nennenswerte Zunahme des Eingangsstroms I_{IN} im High-Pegel-Bereich erreicht, wie dieses bei der digitalen Eingangsschaltung 100' gemäß Fig. 3 und einem Betrieb der Z-Diode Z1' des dort vorgesehenen Spannungsreglers im Stabilisierungsbereich der Fall wäre.

Es hat sich gezeigt, dass ein weiterer Vorteil eines Betriebs der Z-Dioden der ersten Teilschaltung und der zweiten Teilschaltung in ihrem Stabilisierungsbereich darin besteht, dass dadurch auch deren Einfluss auf die bauteilabhängige Toleranz der Ströme der ersten Teilschaltung und der zweiten Teilschaltung am geringsten ist. Der Stromanstieg ΔI wird somit minimal, wenn die Z-Dioden der beiden Teilschaltungen in ihrem jeweiligen Stabilisierungsbereich betrieben werden und der hochohmige Widerstand möglichst groß - gemäß einer bevorzugten Ausführungsform zum Beispiel ≥ 1 MOhm - ist.

Alternativ zu Z-Dioden sind grundsätzlich auch andere spannungsstabilisierende Elemente möglich, wie zum Beispiel herkömmliche Dioden, Leuchtdioden oder Referenzdioden (eine Diode oder mehrere Dioden, die in Reihe oder auch in Reihe mit zum Beispiel einer oder mehreren Z-Dioden geschaltet sind). Die Begrenzung des Stromanstiegs ΔI gemäß Fig. 2 ist selbst mit herkömmlichen Dioden nahezu genauso gut möglich wie mit Z-Dioden, da der differentielle Widerstand von Dioden im Durchlassbereich ähnliche Werte wie manche Z-Dioden im Stabilisierungsbereich nach Erreichen der Durchbruchsspannung haben kann. Lediglich die Streuung der Diodenspannung bei einem bestimmten Strom ist in der Regel größer als bei Z-Dioden. Daraus folgt, dass die Streuung des absoluten Stroms der Teilschaltungen, bei denen Z-Dioden als spannungsstabilisierende Elemente verwendet werden, in der Regel kleiner ist.

In einer besonders bevorzugten Ausführungsform kann vorgesehen sein, dass das stromstabilisierende Element der ersten Teilschaltung durch einen Bipolartransistor, insbesondere durch einen pnp-Transistor, mit einer Basis, einem Emitter und einem Kollektor gebildet ist. Dadurch kann das stromstabilisierende Element der ersten Teilschaltung relativ einfach und kostengünstig realisiert werden.

Vorzugsweise kann das stromstabilisierende Element der zweiten Teilschaltung durch einen Bipolartransistor, insbesondere durch einen npn-Transistor, mit einer Basis, einem Emitter und einem Kollektor gebildet sein. Durch diese Maßnahme kann auch das stromstabilisierende Element der zweiten Teilschaltung relativ einfach und kostengünstig realisiert werden.

In einer vorteilhaften Ausführungsform wird vorgeschlagen, dass die beiden Teilschaltungen derart miteinander verschaltet sind, dass die Basis des Bipolartransistors der ersten Teilschaltung mit dem Kollektor des Bipolartransistors der zweiten Teilschaltung verbunden ist.

In einer weiteren vorteilhaften Ausführungsform können die beiden Teilschaltungen derart miteinander verschaltet sein, dass die Basis des Bipolartransistors der zweiten Teilschaltung mit dem Kollektor des Bipolartransistors der ersten Teilschaltung verbunden ist.

In einer bevorzugten Ausführungsform kann vorgesehen sein, dass die digitale Eingangsschaltung eine dritte Teilschaltung aufweist, die dazu eingerichtet ist, den logischen Zustand der digitalen Eingangsschaltung zu erkennen, und die an einen Ausgang angeschlossen ist, über den ein Ausgangssignal ausgegeben werden kann. In einer weiteren Ausführungsform ist es auch möglich, diese dritte Teilschaltung abgesetzt in einer separaten Geräteeinheit unterzubringen. Diese dritte Teilschaltung ist allerdings nicht zwingend erforderlich. So kann die digitale Eingangsschaltung zum Beispiel dazu verwendet werden, die logischen Zustände des Eingangssignals optisch anzuzeigen. Diese Anzeige kann insbesondere in die zweite Teilschaltung integriert sein, indem die Z-Diode zu diesem Zweck zum Beispiel durch eine LED oder durch eine LED, die in Reihe zu einer Z-Diode oder in Reihe zu einer normalen Diode geschaltet ist, ersetzt wird.

In einer besonders bevorzugten Ausführungsform besteht die Möglichkeit, dass die dritte Teilschaltung ein Koppelelement, das zur Kopplung des Eingangs mit dem Ausgang eingerichtet ist, und ein parallel dazu geschaltetes Schwellwertelement aufweist, wobei das Schwellwertelement dazu ausgebildet ist, dem Koppelelement eine Schaltschwelle zur Verfügung zu stellen, und insbesondere als Widerstand ausgeführt ist. Mit Hilfe des Koppelelements und des Schwellwertelements kann überprüft werden, ob sich die digitale Eingangsschaltung im ersten Zustand (im Low-Pegel-Bereich) oder im zweiten Zustand (im High-Pegel-Bereich) befindet. Vorzugsweise kann das Koppelelement so ausgebildet sein, dass es nur dann leitend ist und den Eingang mit dem Ausgang koppelt, wenn sich die digitale Eingangsschaltung im zweiten Zustand (im High-Pegel-Bereich) befindet. Das Koppelelement kann insbesondere als Optokoppler ausgebildet sein, um eine galvanische Trennung einer Primärseite der digitalen Eingangsschaltung, welche den Eingang umfasst, von einer Sekundärseite, welche den Ausgang umfasst, zu bewirken. Diese galvanische Trennung hat den Vorteil, dass der Ausgang beziehungsweise daran angeschlossene Komponenten im Falle einer Überspannung vor Beschädigungen sowie daraus resultierenden Fehlern geschützt werden können. Das vorzugsweise als Widerstand ausgeführte Schwellwertelement sorgt hier zum einen für die erforderliche Schaltschwelle des Koppelelements und begrenzt im High-Pegel-Bereich zum anderen auch den Strom durch die Leuchtdiode des vorzugsweise das Koppelelement bildenden Optokopplers auf den Wert, für den der Optokoppler spezifiziert ist (zum Beispiel 1 mA). Schließlich trägt der Stromfluss durch den Widerstand auch mit dazu bei, dass die Eingangsschaltung bei einem Eingangsstrom I_{IN} von 1,5 mA noch keinen High-Zustand erkennt. Dieses wird gemäß der Norm IEC61131-2 für einen DC 24 V-Typ 3 Eingang gefordert, sofern die Eingangsspannung zwischen 5 V und 11 V liegt.

In einer alternativen Ausführungsform ist es zum Beispiel auch möglich, das Koppelelement als Transistorstufe auszuführen. Dadurch wird eine digitale Eingangsschaltung in einer nicht potentialgetrennten Ausführungsform geschaffen.

Es hat sich gezeigt, dass der Temperatureinfluss des Eingangsstroms durch eine geeignete Ausgestaltung der ersten Teilschaltung und der zweiten Teilschaltung minimiert werden kann. In einer besonders vorteilhaften Ausführungsform wird vorgeschlagen, dass die Z-Dioden der ersten und der zweiten Teilschaltung einen negativen Temperaturkoeffizienten aufweisen. Wenn derartige Z-Dioden verwendet werden, die einen negativen Temperaturkoeffizienten aufweisen, können sich diese mit den ebenfalls negativen Temperaturkoeffizienten der Basis-Emitter-Spannungen der Transistoren zumindest teilweise aufheben. Das bedeutet mit anderen Worten, dass sich die temperaturabhängigen Spannungsänderungen der Z-Dioden und der Basis-Emitter-Spannungen der Transistoren der beiden Teilschaltungen relativ gut kompensieren können.

Wesentliche Vorteile der vorstehend beschriebenen Schaltungsarchitektur sind insbesondere
- eine einfache und kostengünstige Realisierbarkeit,
- ihre Eignung für alle Typen digitaler Eingangsschaltungen 100 gemäß IEC61131-2 (Typ 1, 2 und 3),
- ihre Eignung für stromziehende und stromliefernde digitale Eingangsschaltungen 100,
- ihre Eignung für digitale Eingangsschaltungen 100 mit und ohne Potentialtrennung, sowie
- ihre Eignung für sicherheitsgerichtete Anwendungen, insbesondere in Sicherheitsschaltvorrichtungen zum fehlersicheren Abschalten einer technischen Anlage, oder in E/A-Modulen.

Die digitale Eingangsschaltung mit der vorstehend beschriebenen Schaltungsarchitektur kann insbesondere mit Hilfe diskreter Bauteile realisiert werden. Alternativ kann eine digitale Eingangsschaltung mit dieser Schaltungsarchitektur auch durch eine integrierte Schaltung in einem IC, insbesondere einem ASIC, realisiert werden.

Die hier beschriebene digitale Eingangsschaltung selbst ist per se nicht sehr verlustarm. Wie groß die elektrische Verlustleistung tatsächlich ist, hängt letztlich von der Dimensionierung der Schaltung ab. Es sind Dimensionierungen möglich, welche die Verlustleitung minimieren (besonders natürlich im High-Pegel-Bereich). Genauso gut könnten auch Dimensionierungen gewählt werden, die größere oder große Verlustleistungen zur Folge haben. Bei einer digitalen Eingangsschaltung des Typs 2 fordert die Norm IEC61131-2 bei einem DC 24V-Eingang im High-Pegel-Bereich zum Beispiel einen minimalen Strom von 6 mA und damit dreimal so viel wie bei einer digitalen Eingangsschaltung des Typs 1 oder des Typs 3 (mindestens 2 mA).

Entsprechend ist bei einer digitalen Eingangsschaltung des Typs 2 dann auch die Verlustleistung im High-Pegel-Bereich mindestens dreimal so groß wie bei einer digitalen Eingangsschaltung des Typs 1 oder des Typs 3. Nichtsdestotrotz kann natürlich auch bei einer digitalen Eingangsschaltung des Typs 2 die Verlustleistung mit der hier beschriebenen Schaltungsarchitektur minimal gehalten werden.

Weitere Merkmale und Vorteile der vorliegenden Erfindung werden deutlich anhand der nachfolgenden Beschreibung eines bevorzugten Ausführungsbeispiels unter Bezugnahme auf die beiliegenden Abbildungen. Darin zeigen:
- Fig. 1: einen idealisierten Verlauf einer Eingangsstrom-Eingangsspannungs-Kennlinie einer digitalen Eingangsschaltung,
- Fig. 2: einen realen Verlauf einer Eingangsstrom-Eingangsspannungs-Kennlinie einer digitalen Eingangsschaltung,
- Fig. 3: eine digitale Eingangsschaltung gemäß dem Stand der Technik,
- Fig. 4: eine digitale Eingangsschaltung, die gemäß einem bevorzugten Ausführungsbeispiel der vorliegenden Erfindung ausgeführt ist.

Unter Bezugnahme auf Fig. 4 soll nachfolgend der Aufbau einer digitalen Eingangsschaltung 100 näher erläutert werden, die gemäß einem bevorzugten Ausführungsbeispiel der vorliegenden Erfindung ausgeführt ist. Die digitale Eingangsschaltung 100 weist einen Eingang 1 auf, mittels dessen die digitale Eingangsschaltung 100 an einen Signalgeber angeschlossen werden kann. Der Signalgeber, welcher der Eingangsschaltung ein digitales Eingangssignal zur Verfügung stellen kann, kann insbesondere eine Sensoreinrichtung oder ein Meldegerät, wie zum Beispiel ein Not-Aus-Taster, ein Not-Halt-Taster, eine Schutztür, eine Schaltmatte, ein Zwei-Hand-Schalter, ein Endlagenschalter oder ein Positionsschalter sein. Das Meldegerät kann zum Beispiel auch berührungslos arbeiten und zum Beispiel als Lichtgitter oder Lichtschranke ausgeführt sein beziehungsweise diese umfassen. Diese von dem Signalgeber zur Verfügung gestellten digitalen Eingangssignale sind binäre Signale und zeichnen sich durch zwei definierte Zustände aus, die insbesondere durch zwei statische Potentiale gegeben sein können. Wie oben bereits erläutert, sind diese beiden Zustände durch unterschiedliche Spannungspegel gekennzeichnet. Dabei handelt es sich um einen ersten Zustand, in dem die Eingangsspannung U_{IN} einen definierten Schwellwert unterschreitet und der häufig auch als Low-Pegel-Zustand bezeichnet wird, sowie um einen zweiten Zustand, in dem die Eingangsspannung U_{IN} einen definierten Schwellwert überschreitet und der häufig auch als High-Pegel-Zustand bezeichnet wird. Der Low-Pegel-Bereich ist durch eine Eingangsspannung U_{IN} ≤ U_{Low,max} sowie durch einen Eingangsstrom I_{IN} ≤ I_{Low,max} gekennzeichnet. Der High-Pegel-Bereich wird durch eine Eingangsspannung U_{High,min} ≤ U_{IN} ≤ U_{High,max} und durch einen Eingangsstrom I_{IN} ≥ I_{High,min} definiert.

Der Schaltungsaufbau der hier vorgestellten digitalen Eingangsschaltung 100 lässt sich aus funktionaler Sicht grob in drei Teilschaltungen 3, 4, 5 aufteilen, die nachfolgend näher erläutert werden sollen.

Die digitale Eingangsschaltung 100 umfasst ein Eingangsfiltermittel 6, das einerseits mit dem Eingang 1 und andererseits auch mit der ersten Teilschaltung 3 verbunden ist. Das Eingangsfiltermittel 6 umfasst einen Widerstand R1 sowie eine diesem nachgeschaltete Kapazität C1, deren eine Elektrode mit Masse GND1 verbunden ist. Die Kapazität C1 dient insbesondere der Glättung der Eingangsspannung U_{IN} und verbessert darüber hinaus auch die elektromagnetische Verträglichkeit der digitalen Eingangsschaltung 100. Beispielsweise kann der Widerstand R1 des Eingangsfiltermittels 6 einen Widerstandswert von 1,5 kOhm aufweisen.

Die erste Teilschaltung 3 umfasst einen ersten Transistor T1, der ein erstes stromstabilisierendes Element der digitalen Eingangsschaltung 100 bildet und einen Ansteuerkreis A1 aufweist, sowie eine erste Z-Diode Z1, die ein erstes spannungsstabilisierendes Element der digitalen Eingangsschaltung 100 bildet. Der erste Transistor T1 ist in dem hier gezeigten Ausführungsbeispiel als pnp-Transistor ausgeführt. Ferner weist die erste Teilschaltung 3 einen Widerstand R2 auf, der zwischen einem Emitter des ersten (pnp-)Transistors T1 und dem Eingangsfiltermittel 6 vorgesehen ist und somit mit dem Eingang 1 der digitalen Eingangsschaltung 100 verbunden ist. Beispielsweise kann der Widerstand R2 einen Widerstandswert von 1,1 kOhm haben. Diese erste Teilschaltung 3 weist ein nicht-ideales Stromausgabeverhalten auf. Sie liefert somit (zumindest) in dem zweiten Zustand (High-Pegel-Zustand) keinen konstanten Ausgangsstrom, sondern einen Ausgangsstrom, der mit zunehmender Eingangsspannung U_{IN} weiter ansteigt und folglich auch eine Zunahme des Eingangsstroms I_{IN} zur Folge hätte.

Die zweite Teilschaltung 4 umfasst einen zweiten Transistor T2, der ein zweites stromstabilisierendes Element der digitalen Eingangsschaltung 100 bildet und einen Ansteuerkreis A2 aufweist, sowie eine zweite Z-Diode Z2, die ein zweites spannungsstabilisierendes Element der digitalen Eingangsschaltung 100 bildet. Der zweite Transistor T2 ist in dem hier gezeigten Ausführungsbeispiel als npn-Transistor ausgeführt. Ferner weist die zweite Teilschaltung 4 einen Widerstand R5 auf, der einen Emitter des zweiten (npn-)Transistors T1 mit Masse GND1 verbindet. Beispielsweise kann der Widerstand R5 einen Widerstandswert von 1,1 kOhm haben, so dass er wie der Widerstand R2 der ersten Teilschaltung 3 dimensioniert ist. Die zweite Teilschaltung 4 weist ebenfalls ein nicht-ideales Stromausgabeverhalten auf. Sie liefert somit (zumindest) in dem zweiten Zustand (High-Pegel-Zustand) ebenfalls keinen konstanten Ausgangsstrom, sondern einen Ausgangsstrom, der mit zunehmender Eingangsspannung U_{IN} weiter ansteigt und folglich auch eine Zunahme des Eingangsstroms I_{IN} zur Folge hätte.

Die digitale Eingangsschaltung 100 weist ferner einen hochohmigen Widerstand R3 auf, über den die erste Teilschaltung 3 mit Masse GND1 verbunden ist und dessen Widerstandswert vorzugsweise ≥ 1 MOhm ist. Dieser hochohmige Widerstand R3, der die erste Teilschaltung 3 mit Masse GND1 verbindet, hat in dem vorliegenden Ausführungsbeispiel die Funktion, sicherzustellen, dass (ausgehend von 0 V) bei einer Erhöhung der Eingangsspannung U_{IN} überhaupt ein elektrischer Strom in die Eingangsschaltung 100 fließen kann. Der Widerstand R3 dient somit gewissermaßen als "Anlauf"-beziehungsweise "Startwiderstand". Konkret ermöglicht dieser Widerstand R3 in dieser "Einschaltphase", dass im Ansteuerkreis A1 des ersten Transistors T1 überhaupt ein Strom fließen kann. Dieser Strom wiederum ist Voraussetzung dafür, dass die erste Teilschaltung 3 einen Strom liefern kann (über den Kollektor des ersten Transistors T1). Dieser Strom ist wiederum Voraussetzung für einen Stromfluss im Ansteuerkreis A2 des zweiten Transistors T2, der schließlich einen Stromfluss in die zweite Teilschaltung 4 (über die Kollektor-Emitter-Strecke des zweiten Transistors T2) ermöglicht. Folglich ist der Widerstand R3 für einen zuverlässigen Betrieb der digitalen Eingangsschaltung 100 des Ausführungsbeispiels gemäß Fig. 4 erforderlich. Unter Umständen können Leckströme zwar dafür sorgen, dass in der vorstehend beschriebenen "Einschaltphase" auch ohne den Widerstand R3 ein Stromfluss im Ansteuerkreis A1 des ersten Transistors T1 zustande kommt, aber zuverlässig und somit praxistauglich ist das in der Regel nicht.

Die dritte Teilschaltung 5 ist vorliegend dazu eingerichtet, den logischen Zustand des Eingangssignals, welches der digitalen Eingangsschaltung 100 über den Eingang 1 zugeführt wird, und somit auch den logischen Zustand der digitalen Eingangsschaltung 100 zu bestimmen. Die dritte Teilschaltung 5 der Eingangsschaltung 100 ist an einen Ausgang 2 angeschlossen, über den eine Ausgangsspannung U_{OUT} ausgegeben werden kann. Diese dritte Teilschaltung 5 umfasst einen ersten Widerstand R4, der an den Kollektor des ersten Transistors T1 angeschlossen ist sowie einen zweiten Widerstand R6. Der zweite Widerstand R6 weist einen ersten Anschluss, der mit dem Ausgang 2 verbunden ist, sowie einen zweiten Anschluss, der mit Masse GND2 verbunden ist, auf. Ferner umfasst die dritte Teilschaltung 5 ein Koppelelement 7, um die erste Teilschaltung 3, die zweite Teilschaltung 4 sowie den Widerstand R4 der dritten Teilschaltung 5 von dem Widerstand R6 und dem Ausgang 2 zu trennen. Dieses Koppelelement 7 ist in dem hier gezeigten Ausführungsbeispiel dazu eingerichtet, eine vollständige galvanische Trennung (d.h. eine Potentialtrennung) der ersten Teilschaltung 3, der zweiten Teilschaltung 4 sowie des ersten Widerstands R4 der dritten Teilschaltung 5 einerseits von dem zweiten Widerstand R6 der dritten Teilschaltung 5 und dem Ausgang 2 andererseits zu bewirken. Die erste Teilschaltung 3, die zweite Teilschaltung 4 sowie der erste Widerstand R4 der dritten Teilschaltung 5 sind somit auf einer Primärseite der digitalen Eingangsschaltung 100 ausgebildet, wohingegen der Ausgang 2 sowie der zweite Widerstand R6 auf einer Sekundärseite der digitalen Eingangsschaltung 100 vorgesehen sind.

In dem hier gezeigten Ausführungsbeispiel ist das Koppelelement 7, welches eine Signalübertragung von der Primärseite zur Sekundärseite ermöglicht, als Optokoppler ausgebildet, welcher primärseitig eine Leuchtdiode 70 und sekundärseitig einen Phototransistor 71 aufweist. Der Phototransistor 71 weist in an sich bekannter Weise einen Emitter auf, der über den Widerstand R6 mit Masse GND2 und darüber hinaus auch mit dem Ausgang 2 der digitalen Eingangsschaltung 100 verbunden ist.

Der erste Widerstand R4 der dritten Teilschaltung 5 sorgt hierbei zum einen für die erforderliche Schaltschwelle des vorliegend als Optokoppler ausgebildeten Koppelelements 7 und begrenzt zum anderen den Strom durch die Leuchtdiode 70 des Optokopplers (im High-Pegel-Bereich) auf den Wert, auf den der Optokoppler ausgelegt ist (beispielsweise auf einen Strom von 1 mA). Schließlich trägt der Strom, der durch den Widerstand R4 fließt, auch mit dazu bei, dass die digitale Eingangsschaltung 100 bei einem Eingangsstrom I_{IN} von 1,5 mA noch keinen High-Pegel-Zustand erkennt. Dieses wird gemäß der Norm IEC61131-2 für einen DC 24 V-Typ 3 Eingang gefordert, sofern die Eingangsspannung zwischen 5 V und 11 V liegt.

Die Erkennung, ob die Eingangsspannung U_{IN} im Low-Pegel-Bereich (erster Zustand der digitalen Eingangsschaltung 100) oder im High-Pegel-Bereich (zweiter Zustand der digitalen Eingangsschaltung 100) liegt, erfolgt mittels des Koppelelements 7 und des parallel dazu geschalteten Widerstands R4, der aus funktionaler Sicht ein Schwellwertelement bildet. Der Widerstand R4 und die Z-Diode Z2 der zweiten Teilschaltung 4 bilden aus funktionaler Sicht gemeinsam einen Spannungsteiler, wobei die Z-Diode Z2 eine Spannungsreferenz zur Verfügung stellt. Der Widerstand R4 ist so dimensioniert, dass nur dann ein Strom durch die Leuchtdiode 70 des vorliegend als Optokoppler ausgebildeten Koppelelements 7 fließt, wenn für die Eingangsspannung U_{IN} gilt: U_{IN} ≥ U_{High,min}. Beispielsweise kann der Widerstand R4 einen Widerstandswert von 2 kOhm haben. Der High-Pegel-Zustand muss spätestens bei U_{IN} = U_{High,min} erkannt werden. Um dieses zu gewährleisten, wird in der Praxis der High-Pegel-Zustand daher schon bei U_{IN} < U_{High,min} erkannt (also innerhalb des Übergangsbereichs). Dann wird die Kollektor-Emitter-Strecke des Phototransistors 71 leitend, so dass am Ausgang 2 ein entsprechendes Ausgangssignal U_{OUT} bereitgestellt werden kann, welches den zweiten Zustand (High-Pegel-Zustand) repräsentiert. Ansonsten wird am Ausgang 2 ein entsprechendes Ausgangssignal U_{OUT} bereitgestellt, welches den ersten Zustand (Low-Pegel-Zustand) repräsentiert.

Die vorstehend erläuterte galvanische Trennung hat den Vorteil, dass der Ausgang 2 beziehungsweise daran angeschlossene Komponenten im Falle einer Überspannung vor Beschädigungen sowie daraus resultierenden Fehlern geschützt werden können. In einer alternativen Ausführungsform ist es zum Beispiel auch möglich, das vorliegend als Optokoppler ausgebildete Koppelelement 7 durch eine Transistorstufe zu ersetzen. Dadurch wird eine digitale Eingangsschaltung 100 in einer nicht potentialgetrennten Ausführungsform geschaffen.

Die erste und die zweite Teilschaltung 3, 4 bilden zwei Stromquellen (die zweite Teilschaltung 4 könnte auch als Stromsenke bezeichnet werden), die so ausgebildet und derart miteinander verschaltet sind, dass sich das nicht-ideale Stromausgabeverhalten der ersten Teilschaltung 3 und das nicht-ideale Stromausgabeverhalten der zweiten Teilschaltung 4 im zweiten Zustand (d.h. im High-Pegel-Bereich beziehungsweise zumindest in einem Teil des High-Pegel-Bereichs) gegenseitig zumindest teilweise kompensieren können. Die erste Teilschaltung 3 und die zweite Teilschaltung 4 sind hierbei kreuzweise hintereinandergeschaltet. Dabei ist die Basis des Transistors T1 der ersten Teilschaltung 3, die einen Teil des Ansteuerkreises A1 des Transistors T1 bildet, mit dem Kollektor des Bipolartransistors T2 der zweiten Teilschaltung 4 verbunden. Darüber hinaus ist die Basis des Bipolartransistors T2 der zweiten Teilschaltung 4, die einen Teil des Ansteuerkreises A2 des Transistors T2 bildet, über den Widerstand R4 mit dem Kollektor des Bipolartransistors T1 der ersten Teilschaltung 3 verbunden.

Während des Betriebs der digitalen Eingangsschaltung 100 und des Empfangs von Eingangssignalen im High-Pegel-Bereich beziehungsweise zumindest in einem Teil des High-Pegel-Bereichs fließt ein Strom aus der ersten Teilschaltung 3 in die dritte Teilschaltung 5, mittels derer der logische Zustand des Eingangssignals U_{IN} bestimmt werden kann. Eine Kompensation des nicht-idealen Stromausgabeverhaltens der beiden Teilschaltungen 3, 4 wird dadurch erreicht, dass der Strom, der durch die erste Z-Diode Z1 fließt, im Wesentlichen aus dem stabilisierten Strom der zweiten Teilschaltung 4 besteht und der Strom, der durch die zweite Z-Diode Z2 fließt, im Wesentlichen aus dem stabilisierten Strom der ersten Teilschaltung 3 besteht. Die gute gegenseitige Stabilisierung der Ströme der beiden Teilschaltungen 3, 4 und somit des gesamten Eingangsstroms der Eingangsschaltung 100 beruht bei dieser Schaltungsarchitektur darauf, dass die Ströme der Z-Dioden Z1, Z2 und in Folge dessen auch die Spannungen der Z-Dioden Z1, Z2 stabil gehalten werden. Die gegenseitige Stabilisierung der Ströme der beiden Teilschaltungen 3, 4 ist am größten, wenn sich die Z-Dioden Z1, Z2 in ihrem jeweiligen Stabilisierungsbereich befinden. Die Ströme der beiden Ansteuerkreise A1, A2 machen im zweiten Zustand (High-Pegel-Bereich) nur noch einen kleinen Teil der Ströme der beiden Teilschaltungen 3, 4 aus. Der Transistor T2 der zweiten Teilschaltung 4 kann im Low-Pegel-Bereich einen Basisstrom I_{B,T1} des Transistors T1 der ersten Teilschaltung 3 steuern. Umgekehrt kann der Transistor T1 der ersten Teilschaltung 3 im Low-Pegel-Bereich einen Basisstrom I_{B,T2} des Transistors T2 der zweiten Teilschaltung 4 steuern. Im High-Pegel-Bereich steuern die Transistoren T1, T2 vor allem die Ströme durch die Z-Dioden Z1, Z2 der jeweils anderen Teilschaltung 3, 4.

Im logischen High-Pegel-Bereich, der den zweiten Zustand der digitalen Eingangsschaltung 100 charakterisiert, werden die Z-Diode Z1 der ersten Teilschaltung 3 und die Z-Diode Z2 der zweiten Teilschaltung 4 jeweils in ihrem Stabilisierungsbereich betrieben. Das bedeutet, dass der Strom der ersten Teilschaltung 3 in diesem Zustand im Wesentlichen durch die Z-Diode Z2 der zweiten Teilschaltung 4 fließt. Der elektrische Strom durch die Z-Diode Z1 der ersten Teilschaltung 3 fließt in diesem Zustand nahezu vollständig in die zweite Teilschaltung 4, sofern der Widerstand R3 hinreichend groß gewählt ist. Beispielsweise kann der Widerstand R3 einen Widerstandswert von 1 MOhm haben. Die Ströme der beiden Teilschaltungen 3, 4 fließen aber auch schon nahezu vollständig durch die Z-Dioden Z1, Z2 der jeweils anderen Teilschaltung 3, 4, bevor die beiden Z-Dioden Z1, Z2 in ihrem jeweiligen Stabilisierungsbereich betrieben werden, insbesondere im Übergang der Z-Dioden Z1, Z2 vom Sperrbereich in den leitenden Bereich. Durch die kreuzweise Hintereinanderschaltung der ersten Teilschaltung 3 und der zweiten Teilschaltung 4 fließen zumindest bei Eingangssignalen U_{IN} im High-Pegel-Bereich (zweiter Zustand der digitalen Eingangsschaltung 100) durch beide Z-Dioden Z1, Z2 der ersten und zweiten Teilschaltung 3, 4 jeweils die im Wesentlichen konstanten Ströme der jeweils anderen Teilschaltung 3, 4. Insgesamt bleibt dadurch auch der gesamte Eingangsstrom I_{IN} im Wesentlichen konstant. Durch diese Maßnahme ist es möglich, den Stromanstieg ΔI im High-Pegel-Bereich zu minimieren, so dass ein Eingangsstrom-Eingangsspannungs-Kennlinienverlauf der digitalen Eingangsschaltung 100 erhalten werden kann, der nahezu dem idealen Kennlinienverlauf gemäß Fig. 1 entspricht. Durch eine Minimierung des Stromanstiegs ΔI im High-Pegel-Bereich, der mit der hier beschriebenen Schaltungsarchitektur vorzugsweise gegen null tendiert, kann die Verlustleistung der digitalen Eingangsschaltung 100 in vorteilhafter Weise minimiert werden.

Ein wesentlicher Vorteil der hier beschriebenen Schaltungsarchitektur besteht darin, dass bei Verwendung von Z-Dioden Z1, Z2 für die erste Teilschaltung 3 und für die zweite Teilschaltung 4 deren Dimensionierung sehr einfach so gewählt werden kann, dass zumindest für Eingangssignale U_{IN} im High-Pegel-Bereich durch beide Z-Dioden Z1, Z2 ein ausreichend großer Strom fließt, um diese in ihrem Stabilisierungsbereich oder zumindest nahe an diesem betreiben zu können. Dieses wird ohne eine nachteilige nennenswerte Zunahme des Eingangsstroms I_{IN} im High-Pegel-Bereich erreicht, wie dieses bei der digitalen Eingangsschaltung 100' gemäß Fig. 3 und einem Betrieb der Z-Diode Z1' des dort vorgesehenen Spannungsreglers im Stabilisierungsbereich der Fall wäre.

Ein weiterer Vorteil eines Betriebs der Z-Dioden Z1, Z2 der ersten Teilschaltung 3 und der zweiten Teilschaltung 4 in ihrem Stabilisierungsbereich besteht darin, dass dadurch auch deren Einfluss auf die bauteilabhängige Toleranz der Ströme der ersten Teilschaltung 3 und der zweiten Teilschaltung 4 am geringsten ist. Der Stromanstieg ΔI wird somit minimal, wenn die Z-Dioden Z1, Z2 der beiden Teilschaltungen 3, 4 in ihrem Stabilisierungsbereich betrieben werden und der Vorwiderstand R3 der Z-Diode Z1 der ersten Teilschaltung 3 möglichst groß gewählt wird (zum Beispiel - wie oben bereits erwähnt - R3 = 1 MOhm oder höher). Die beiden Z-Dioden Z1, Z2 können zum Beispiel eine Durchbruchsspannung von 2,7 V haben.

Der Temperatureinfluss des Eingangsstroms I_{IN} kann durch eine geeignete Ausgestaltung der ersten Teilschaltung 3 und der zweiten Teilschaltung 4 minimiert werden. Beispielsweise können zu diesem Zweck Z-Dioden Z1, Z2 verwendet werden, die einen negativen Temperaturkoeffizienten aufweisen, damit sich diese mit den ebenfalls negativen Temperaturkoeffizienten der Basis-Emitter-Spannungen der Transistoren T1, T2 zumindest teilweise aufheben. Das bedeutet mit anderen Worten, dass sich die temperaturabhängigen Spannungsänderungen der Z-Dioden Z1, Z2 und der Basis-Emitter-Spannungen der Transistoren T1, T2 der ersten und zweiten Teilschaltung 3, 4 relativ gut kompensieren können.

Alternativ ist es möglich, durch Hinzufügen je einer herkömmlichen Diode in Serie zu der Z-Diode Z1 der ersten Teilschaltung 3 und zu der Z-Diode Z2 der zweiten Teilschaltung 4 ebenfalls einen Ausgleich der Temperaturkoeffizienten der Basis-Emitter-Spannungen der Transistoren T1, T2 zu erhalten.

Die Vorteile der hier beschriebenen Schaltungsarchitektur sind insbesondere
- eine einfache und kostengünstige Realisierbarkeit,
- ihre Eignung für alle Typen digitaler Eingangsschaltungen 100 gemäß IEC61131-2 (Typ 1, 2 und 3),
- ihre Eignung für stromziehende und stromliefernde digitale Eingangsschaltungen 100,
- ihre Eignung für digitale Eingangsschaltungen 100 mit und ohne Potentialtrennung, sowie
- ihre Eignung für sicherheitsgerichtete Anwendungen, insbesondere in Sicherheitsschaltvorrichtungen zum fehlersicheren Abschalten einer technischen Anlage, oder in E/A-Modulen.

Vorstehend wurde eine digitale Eingangsschaltung 100 erläutert, die mit Hilfe diskreter Bauteile realisiert wurde. Alternativ kann eine digitale Eingangsschaltung 100 mit dieser Schaltungsarchitektur auch durch eine integrierte Schaltung in einem IC, insbesondere einem ASIC, realisiert werden.

In einer weiteren Ausführungsform ist es auch möglich, die dritte Teilschaltung 5, welche für die Erkennung des logischen Zustands des Eingangssignals U_{IN} vorgesehen ist, auch abgesetzt in einer separaten Geräteeinheit unterzubringen.

## Patentansprüche

1. Digitale Eingangsschaltung (100) zum Empfangen digitaler Eingangssignale eines Signalgebers, umfassend
- einen Eingang (1), über den der Eingangsschaltung (100) das Eingangssignal zuführbar ist, wobei die Eingangsschaltung (100) einen ersten logischen Zustand, der einen Low-Pegel-Zustand bildet, einnimmt, wenn das Eingangssignal einen unteren Schwellwert erreicht oder unterschreitet, und wobei die Eingangsschaltung (100) einen zweiten logischen Zustand, der einen High-Pegel-Zustand bildet, einnimmt, wenn das Eingangssignal einen oberen Schwellwert erreicht oder überschreitet,
- eine erste Teilschaltung (3), die zumindest ein stromstabilisierendes Element (T1) mit einem Ansteuerkreis (A1) und zumindest ein spannungsstabilisierendes Element aufweist, wobei die erste Teilschaltung (3) zumindest in dem zweiten Zustand ein nicht-ideales Stromausgabeverhalten aufweist und keinen konstanten Ausgangsstrom, sondern einen Ausgangsstrom, der mit zunehmender Eingangsspannung (U_{IN}) weiter ansteigt, liefert, sowie
- eine zweite Teilschaltung (4), die zumindest ein stromstabilisierendes Element (T2) mit einem Ansteuerkreis (A2) und zumindest ein spannungsstabilisierendes Element aufweist, wobei die zweite Teilschaltung (4) zumindest in dem zweiten Zustand ein nicht-ideales Stromausgabeverhalten aufweist und keinen konstanten Ausgangsstrom, sondern einen Ausgangsstrom, der mit zunehmender Eingangsspannung (U_{IN}) weiter ansteigt, liefert
wobei die erste Teilschaltung (3) und die zweite Teilschaltung (4) so ausgeführt und derart miteinander verschaltet sind, dass zumindest in dem zweiten Zustand ein elektrischer Strom, der durch das spannungsstabilisierende Element der ersten Teilschaltung (3) fließt, nahezu vollständig aus einem stabilisierten Strom der zweiten Teilschaltung (4) besteht und ein elektrischer Strom, der durch das spannungsstabilisierende Element der zweiten Teilschaltung (4) fließt, nahezu vollständig aus einem stabilisierten Strom der ersten Teilschaltung (3) besteht, so dass sich das nicht-ideale Stromausgabeverhalten der ersten Teilschaltung (3) und das nicht-ideale Stromausgabeverhalten der zweiten Teilschaltung (4) zumindest in dem zweiten Zustand gegenseitig zumindest teilweise kompensieren, wobei die spannungsstabilisierenden Elemente der ersten und der zweiten Teilschaltung (3, 4) Z-Dioden (Z1, Z2) sind, die in dem zweiten Zustand in ihrem Stabilisierungsbereich betrieben werden,
wobei die digitale Eingangsschaltung (100) einen hochohmigen Widerstand (R3) aufweist, über den die erste Teilschaltung (3) mit Masse (GND1) verbunden ist und dessen Widerstandswert ≥ 750 kOhm ist, wobei der hochohmige Widerstand (R3) einen Vorwiderstand der Z-Diode (Z1) der ersten Teilschaltung (3) bildet und direkt mit Masse (GND1) verbunden ist.

2. Digitale Eingangsschaltung (100) nach Anspruch 1, **dadurch gekennzeichnet, dass** der Widerstandswert des hochohmigen Widerstands (R3) ≥ 1 MOhm ist.

3. Digitale Eingangsschaltung (100) nach einem der Ansprüche 1 oder 2, **dadurch gekennzeichnet, dass** das stromstabilisierende Element (T1) der ersten Teilschaltung (3) durch einen Bipolartransistor (T1), insbesondere durch einen pnp-Transistor, mit einer Basis, einem Emitter und einem Kollektor gebildet ist.

4. Digitale Eingangsschaltung (100) nach einem der Ansprüche 1 bis 3, **dadurch gekennzeichnet, dass** das stromstabilisierende Element (T2) der zweiten Teilschaltung (4) durch einen Bipolartransistor (T2), insbesondere durch einen npn-Transistor, mit einer Basis, einem Emitter und einem Kollektor gebildet ist.

5. Digitale Eingangsschaltung (100) nach Anspruch 4, **dadurch gekennzeichnet, dass** die beiden Teilschaltungen (3, 4) derart miteinander verschaltet sind, dass die Basis des Bipolartransistors (T1) der ersten Teilschaltung (3) mit dem Kollektor des Bipolartransistors (T2) der zweiten Teilschaltung (4) verbunden ist.

6. Digitale Eingangsschaltung (100) nach einem der Ansprüche 4 oder 5, **dadurch gekennzeichnet, dass** die beiden Teilschaltungen (3, 4) derart miteinander verschaltet sind, dass die Basis des Bipolartransistors (T2) der zweiten Teilschaltung (4) mit dem Kollektor des Bipolartransistors (T1) der ersten Teilschaltung (3) verbunden ist.

7. Digitale Eingangsschaltung (100) nach einem der Ansprüche 1 bis 6, **dadurch gekennzeichnet, dass** die digitale Eingangsschaltung (100) eine dritte Teilschaltung (5) aufweist, die dazu eingerichtet ist, den logischen Zustand der digitalen Eingangsschaltung (100) zu erkennen, und die an einen Ausgang (2) angeschlossen ist, über den ein Ausgangssignal ausgegeben werden kann.

8. Digitale Eingangsschaltung (100) nach Anspruch 7, **dadurch gekennzeichnet, dass** die dritte Teilschaltung (5) ein Koppelelement (7), das zur Kopplung des Eingangs (1) mit dem Ausgang (2) eingerichtet ist, und ein parallel dazu geschaltetes Schwellwertelement aufweist, wobei das Schwellwertelement dazu ausgebildet ist, dem Koppelelement (7) eine Schaltschwelle zur Verfügung zu stellen und insbesondere als Widerstand (R4) ausgeführt ist.

9. Digitale Eingangsschaltung (100) nach einem der Ansprüche 2 bis 8, **dadurch gekennzeichnet, dass** die Z-Dioden (Z1, Z2) der ersten und der zweiten Teilschaltung (3, 4) einen negativen Temperaturkoeffizienten aufweisen.

## Claims

1. Digital input circuit (100) for receiving digital input signals from a signal generator, comprising
- an input (1) via which the input signal is able to be supplied to the input circuit (100), wherein the input circuit (100) assumes a first logic state, constituting a low-level state, when the input signal reaches or falls below a lower threshold value, and wherein the input circuit (100) assumes a second logic state, constituting a high-level state, when the input signal reaches or exceeds an upper threshold value,
- a first subcircuit (3) which has at least one current-stabilizing element (T1) comprising a control circuit (A1) and at least one voltage-stabilizing element, wherein the first subcircuit (3), at least in the second state, exhibits non-ideal current output behaviour and does not deliver a constant output current but rather an output current which increases further as the input voltage (U_{IN}) increases, and
- a second subcircuit (4) which has at least one current-stabilizing element (T2) comprising a control circuit (A2) and at least one voltage-stabilizing element, wherein the second subcircuit (4), at least in the second state, exhibits non-ideal current output behaviour and does not deliver a constant output current but rather an output current which increases further as the input voltage (U_{IN}) increases,
wherein the first subcircuit (3) and the second subcircuit (4) are embodied and connected to one another in such a way that, at least in the second state, an electrical current flowing through the voltage-stabilizing element of the first subcircuit (3) consists virtually completely of a stabilized current from the second subcircuit (4), and an electrical current flowing through the voltage-stabilizing element of the second subcircuit (4) consists virtually completely of a stabilized current from the first subcircuit (3), such that the non-ideal current output behaviour of the first subcircuit (3) and the non-ideal current output behaviour of the second subcircuit (4) at least partially compensate for one another at least in the second state, wherein the voltage-stabilizing elements of the first and second subcircuit (3, 4) are Zener diodes (Z1, Z2) which are operated in their stabilization range in the second state,
wherein the digital input circuit (100) has a high-impedance resistor (R3) via which the first subcircuit (3) is connected to earth (GND1) and the resistance value of which is ≥ 750 kOhm, wherein the high-impedance resistor (R3) forms a series resistor with the Zener diode (Z1) of the first subcircuit (3) and is connected directly to earth (GND1).

2. Digital input circuit (100) according to Claim 1, **characterized in that** the resistance value of the high-impedance resistor (R3) is ≥ 1 MOhm.

3. Digital input circuit (100) according to either of Claims 1 and 2, **characterized in that** the current-stabilizing element (T1) of the first subcircuit (3) is formed by a bipolar transistor (T1), in particular by a pnp transistor, comprising a base, an emitter and a collector.

4. Digital input circuit (100) according to one of Claims 1 to 3, **characterized in that** the current-stabilizing element (T2) of the second subcircuit (4) is formed by a bipolar transistor (T2), in particular by an npn transistor, comprising a base, an emitter and a collector.

5. Digital input circuit (100) according to Claim 4, **characterized in that** the two subcircuits (3, 4) are connected to one another in such a way that the base of the bipolar transistor (T1) of the first subcircuit (3) is connected to the collector of the bipolar transistor (T2) of the second subcircuit (4).

6. Digital input circuit (100) according to either of Claims 4 and 5, **characterized in that** the two subcircuits (3, 4) are connected to one another in such a way that the base of the bipolar transistor (T2) of the second subcircuit (4) is connected to the collector of the bipolar transistor (T1) of the first subcircuit (3).

7. Digital input circuit (100) according to one of Claims 1 to 6, **characterized in that** the digital input circuit (100) has a third subcircuit (5) which is configured to identify the logic state of the digital input circuit (100) and which is connected to an output (2) via which an output signal can be output.

8. Digital input circuit (100) according to Claim 7, **characterized in that** the third subcircuit (5) has a coupling element (7), which is configured to couple the input (1) to the output (2), and a threshold value element connected in parallel therewith, wherein the threshold value element is designed to provide the coupling element (7) with a switching threshold and is embodied in particular as a resistor (R4).

9. Digital input circuit (100) according to one of Claims 2 to 8, **characterized in that** the Zener diodes (Z1, Z2) of the first and of the second subcircuit (3, 4) have a negative temperature coefficient.

## Revendications

1. Circuit d'entrée logique (100) destiné à recevoir des signaux d'entrée logique d'un transmetteur de signaux, comprenant
- une entrée (1), par le biais de laquelle le signal d'entrée peut être acheminé au circuit d'entrée (100), le circuit d'entrée (100) adoptant un premier état logique, qui forme un état de niveau bas, lorsque le signal d'entrée atteint ou devient inférieur à une valeur de seuil basse, et le circuit d'entrée (100) adoptant un deuxième état logique, qui forme un état de niveau haut, lorsque le signal d'entrée atteint ou dépasse une valeur de seuil haute,
- un premier circuit partiel (3), qui possède au moins un élément stabilisateur de courant (T1) avec un circuit de commande (A1) et au moins un élément stabilisateur de tension, le premier circuit partiel (3) présentant, au moins dans le deuxième état, un comportement de sortie de courant non idéal et ne délivrant pas un courant de sortie constant, mais un courant de sortie qui continue d'augmenter avec l'augmentation de la tension d'entrée (U_{IN}), et
- un deuxième circuit partiel (4), qui possède au moins un élément stabilisateur de courant (T2) avec un circuit de commande (A2) et au moins un élément stabilisateur de tension, le deuxième circuit partiel (4) présentant, au moins dans le deuxième état, un comportement de sortie de courant non idéal et ne délivrant pas un courant de sortie constant, mais un courant de sortie qui continue d'augmenter avec l'augmentation de la tension d'entrée (U_{IN}),
le premier circuit partiel (3) et le deuxième circuit partiel (4) étant réalisés et interconnectés de telle sorte qu'au moins dans le deuxième état, un courant électrique, qui circule à travers l'élément stabilisateur de tension du premier circuit partiel (3), se compose presque entièrement d'un courant stabilisé du deuxième circuit partiel (4) et qu'un courant électrique, qui circule à travers l'élément stabilisateur de tension du deuxième circuit partiel (4), se compose presque entièrement d'un courant stabilisé du premier circuit partiel (3), de sorte que le comportement de sortie de courant non idéal du premier circuit partiel (3) et le comportement de sortie de courant non idéal du deuxième circuit partiel (4) se compensent mutuellement au moins partiellement au moins dans le deuxième état, les éléments stabilisateurs de tension du premier et du deuxième circuit partiel (3, 4) étant des diodes Zener (Z1, Z2) qui, dans le deuxième état, fonctionnent dans leur plage de stabilisation,
le circuit d'entrée logique (100) présentant une résistance à forte valeur ohmique (R3) par le biais de laquelle le premier circuit partiel (3) est relié à la masse (GND1) et dont la valeur ohmique est ≥ 750 kOhms, la résistance à forte valeur ohmique (R3) formant une résistance série de la diode Zener (Z1) du premier circuit partiel (3) et étant reliée directement à la masse (GND1).

2. Circuit d'entrée logique (100) selon la revendication 1, **caractérisé en ce que** la valeur ohmique de la résistance à forte valeur ohmique (R3) est ≥ 1 MOhm.

3. Circuit d'entrée logique (100) selon l'une des revendications 1 ou 2, **caractérisé en ce que** l'élément stabilisateur de courant (T1) du premier circuit partiel (3) est formé par un transistor bipolaire (T1), notamment par un transistor PNP, comprenant une base, un émetteur et un collecteur.

4. Circuit d'entrée logique (100) selon l'une des revendications 1 à **3, caractérisé en ce que l'élément** stabilisateur de courant (T2) du deuxième circuit partiel (4) est formé par un transistor bipolaire (T2), notamment par un transistor NPN, comprenant une base, un émetteur et un collecteur.

5. Circuit d'entrée numérique (100) selon la revendication **4, caractérisé en ce que** les deux circuits partiels (3, 4) sont interconnectés de telle sorte que la base du transistor bipolaire (T1) du premier circuit partiel (3) est reliée au collecteur du transistor bipolaire (T2) du deuxième circuit partiel (4).

6. Circuit d'entrée numérique (100) selon l'une des revendications 4 ou 5, **caractérisé en ce que** les deux circuits partiels (3, 4) sont interconnectés de telle sorte que la base du transistor bipolaire (T2) du deuxième circuit partiel (4) est reliée au collecteur du transistor bipolaire (T1) du premier circuit partiel (3).

7. Circuit d'entrée logique (100) selon l'une des revendications 1 à 6, **caractérisé en ce que** le circuit d'entrée logique (100) possède un troisième circuit partiel (5), lequel est conçu pour reconnaître l'état logique du circuit d'entrée logique (100) et qui est raccordé à une sortie (2) par le biais de laquelle peut être émis un signal de sortie.

8. Circuit d'entrée logique (100) selon la revendication 7, **caractérisé en ce que** le troisième circuit partiel (5) possède un élément de couplage (7), qui est conçu pour coupler l'entrée (1) à la sortie (2), et un élément de valeur de seuil branché en parallèle à celui-ci, l'élément de valeur de seuil étant configuré pour mettre un seuil de commutation à disposition de l'élément de couplage (7) et étant notamment réalisé sous la forme d'une résistance (R4).

9. Circuit d'entrée logique (100) selon l'une des revendications 2 à 8, **caractérisé en ce que** les diodes Zener (Z1, Z2) des premier et deuxième circuits partiels (3, 4) présentent un coefficient de température négatif.
